**Europäisches Patentamt**

(19) **European Patent Office**

**Office européen des brevets**

(11) Veröffentlichungsnummer: **0 008 007**
**B1**

(12) # EUROPÄISCHE PATENTSCHRIFT

(45) Veröffentlichungstag der Patentschrift:
**29.09.82**

(51) Int. Cl.³: **G 01 R 31/12**, G 01 R 31/16,
G 01 N 33/38

(21) Anmeldenummer: **79102391.4**

(22) Anmeldetag: **11.07.79**

(54) Verfahren und Vorrichtung zur Qualitätsprüfung keramischer Bauelemente.

(30) Priorität: **08.08.78 DE 2834695**

(43) Veröffentlichungstag der Anmeldung:
**20.02.80 Patentblatt 80/4**

(45) Bekanntmachung des Hinweises auf die Patenterteilung:
**29.09.82 Patentblatt 82/39**

(84) Benannte Vertragsstaaten:
**AT FR GB SE**

(56) Entgegenhaltungen:
**Ceramic Bulletin, Band 55, Nr. 5, 1976 J. E. Garnier et al. «Application of Acoustic Emmission to Evaluation of Dielectric Breakdown in Insulator Materials»**

(73) Patentinhaber: **SIEMENS AKTIENGESELLSCHAFT**
**Berlin und München, Postfach 22 02 61,**
**D-8000 München 22 (DE)**

(72) Erfinder: **Lubitz, Karl, Dr., Brennerstrasse 5,**
**D-8012 Ottobrunn (DE)**
Erfinder: **Schuhmann, Werner Peter,**
**Schaftlachstrasse 15, D-8000 München 70 (DE)**
Erfinder: **Drew, Jeffrey Michael, Stockmannstrasse 38,**
**D-8000 München 71 (DE)**

## Verfahren und Vorrichtung zur zerstörungsfreien Qualitätsprüfung keramischer Bauelemente aus halbleitender Keramik.

Die Erfindung betrifft ein Verfahren und eine Vorrichtung zur zerstörungsfreien Qualitätsprüfung keramischer Bauelemente aus halbleitender Keramik, insbesondere zur Qualitätsprüfung von Kaltleitern, unter elektrischer Belastung mit Hilfe der Schallemissionsanalyse.

Bei der Prüfung von keramischen Bauelementen, z.B. Leistungskaltleitern, spielt das Kriterium Schaltfestigkeit eine entscheidende Rolle. Die Anwender schreiben eine bestimmte Schaltanordnung und Prüfspannung vor und verlangen, dass der Kaltleiter unter diesen Bedingungen eine zumeist hohe Zahl von Schaltungen ohne jede Schädigung übersteht. Üblicherweise wird die Schaltfestigkeit dadurch geprüft, dass die Spannung an den Kaltleiter gelegt wird und der Widerstand des Kaltleiters vor und nach der Schaltprüfung gemessen wird. Erhöht sich der Widerstand nach der Prüfung, so muss angenommen werden, dass während der elektrischen Belastung mechanische Defekte im Kaltleiter erzeugt oder bestehende Defekte vergrössert wurden. Geringfügige Defekte, die zu einer allmählichen Zerstörung der Probe bei einer grossen Zahl von Schaltungen unter Prüfspannung (Dauertest) führen könnten, lassen sich nach dieser Methode durch eine einfache Schaltprüfung nicht nachweisen.

Aus den elektrischen Kenngrössen des Kaltleiters, die alle zerstörungsfrei gemessen werden können, lässt sich in der Regel keine sichere Prognose über die Schaltfestigkeit ableiten. Geringfügige Inhomogenitäten im Inneren der Keramik, Mikrorisse, Lunker u.ä. können bei der Schaltprüfung sofort oder im Dauerversuch allmählich zu einer Zerstörung der Keramik führen.

Einige Verfahren zur Prüfung auf mechanische Defekte wurden bereits untersucht und werden teilweise in der Fertigung verwendet. Hierzu gehören Dämpfungsmessungen mit Ultraschall. Ein derartiges Verfahren liefert wegen der natürlichen Porosität der Keramik und der oft geringen Ausdehnung der Primärdefekte keine eindeutige Aussage zur Schaltfestigkeit. Das gleiche gilt für elektrische Dämpfungsmessungen, mit denen nur in Sonderfällen gute Ergebnisse zu erzielen sind.

Diesen bekannten Verfahren ist gemeinsam, dass sie nur vorhandene mechanische Defekte aufspüren. Der grössere Teil der Schaltausfälle wird durch Widerstandsinhomogenitäten in der zuerst mechanisch störungsfreien Keramik verursacht.

J.E. Garnier beschreibt in dem Ceramic Bulletin, Band 55, Nr. 5, 1976 auf den Seiten 533 und 534 die Anwendung der Schallemission zur Auswertung des dielektrischen Durchschlagverhaltens in Isolatoren. Dabei wird die Prüfspannung langsam hochgeregelt und die Zahl der elektrischen Durchschläge gezählt. Dieses Verfahren erlaubt am Material zwischen verschiedenen elektrischen Durchbruchmechanismen zu unterscheiden.

Der Erfindung liegt die Aufgabe zugrunde, mit möglichst einfachen Mitteln das eingangs erwähnte Verfahren und eine Vorrichtung zur Durchführung dieses Verfahrens zu realisieren. Diese Aufgabe wird dadurch gelöst, dass eine elektrische Überspannung einmalig an das zu messende Bauelement angelegt wird, wobei gleichzeitig die Schallemissionsanalyse ausgeführt wird und aus dieser danach eine Aussage über den Werkstoffzustand, und zwar über die durch das Anlegen der elektrischen Überspannung eventuell entstehende mechanische Schädigung oder eine bestehende mechanische Vorschädigung des Werkstoffes gewonnen wird.

Durch das Anlegen einer einmaligen elektrischen Überspannung wird festgestellt, ob die Probe (Bauelement) dieser Belastung bei Normalspannung gewachsen ist. Gleichzeitig wird sichergestellt, dass die Probe durch die einmalige Überlastung nicht geschädigt wurde. Damit ist mit einem einmaligen Test erreicht, dass die Probe bei Dauerbelastung unter normaler Spannung nicht geschädigt wird. Auf diese Weise kann ein Dauertest bei Normal- oder Spezifikationsspannung ersetzt werden.

Mit der Schallemissionsanalyse kann auch das Bestehen einer mechanischen Vorschädigung des Kaltleiters nachgewiesen werden. Unmittelbar nach Anlegen einer Spannung an den Kaltleiter erwärmt sich dieser in der Umgebung der Vorschädigung ungleichmässig, da der homogene Stromfluss dort gestört ist. Die Rissflächen reiben gegeneinander und erzeugen Schallpulse, auch wenn sich der Riss nicht ausdehnt.

Selbst wenn die Probe im thermischen Gleichgewicht ist, werden Schallpulse erzeugt, ohne dass sich der mechanische Defekt ausbreitet. Der elektrische Übergangswiderstand von Rissfläche zu Rissfläche ist umso kleiner, je stärker die Flächen aufeinandergepresst werden, was bei höheren Temperaturen stärker der Fall ist. Wenn der Übergangswiderstand abnimmt, sinkt die elektrische Eigenerwärmung und damit die Temperatur in der Umgebung des Risses, und der Anpresspunkt der Rissflächen wird wieder kleiner. Es entstehen in der Umgebung der Vorschädigung Temperaturschwingungen, die über das Aneinanderreiben der Rissflächen solange Schallpulse erzeugen, wie die elektrische Spannung am Kaltleiter anliegt.

Durch die gleichzeitige Anwendung von elektrischer Belastung und Schallemissionsanalyse lässt sich in empfindlicher Weise die Existenz von Vorschädigungen (die z.B. bei der Probenherstellung erfolgt sind) nachweisen, die zu klein sind, um eine Erhöhung des Kaltleiterwiderstandes zu bewirken und die selbst bei elektrischer Überlastprüfung erst nach einer grossen Zahl von Schaltbelastungen zu einer allmählichen mechanischen Zerstörung des Kaltleiters führen.

Nach einer Weiterbildung der Erfindung wird die Schallmessung erst unmittelbar nach dem Einschalten der Spannung aktiviert. Auf diese Weise werden während des Einschaltens der Spannung entstehende elektrische Impulse, die aufgrund der elektrischen Kopplung in den Verstärkereinheiten Schallimpulse vortäuschen, eliminiert und die Auswertung wesentlich vereinfacht.

Eine Vorrichtung zur Durchführung des Verfahrens mit Mitteln zum Anlegen einer elektrischen Prüfspannung an das Bauelement über zwei elektrische Kontakte einer Halterung und mit Mitteln zur gleichzeitigen Durchführung der Schallemissionsanalyse über einen Schallaufnehmer, der an der Oberfläche des Bauelementes durch die Halterung gehalten ist, besteht darin, dass der Schallaufnehmer am Bauelement durch die Halterung federnd gehalten ist, dass die elektrischen Kontakte der Halterung als Federn ausgebildet sind, zwischen die das Bauelement eingespannt ist, wobei alle Teile der Halterung konstruktiv so ausgelegt sind, dass sie sich relativ leicht gegeneinander verdrehen lassen und wobei alle nicht elektrischen Kontaktpunkte dieser Halterung mit dem zu messenden Bauelement aus dem Kunststoff Polytetrafluoräthylen bestehen. Eine entsprechende Vorrichtung garantiert vor allem einen schnellen Bauteilwechsel. Ausserdem bleiben störende Schallpulse, die eventuell durch Reibung zwischen der sich schnell erwärmenden und sich ausdehnenden Probe und der Halterung entstehen könnten, unterdrückt.

Die Erfindung wird anhand der Figuren erläutert. Es zeigen:

Figur 1 eine schematische Darstellung eines Messaufbaues nach der Erfindung und

Figur 2 bis 4 den zeitlichen Verlauf des Stromes und der Schallemission bei verschiedenen Proben.

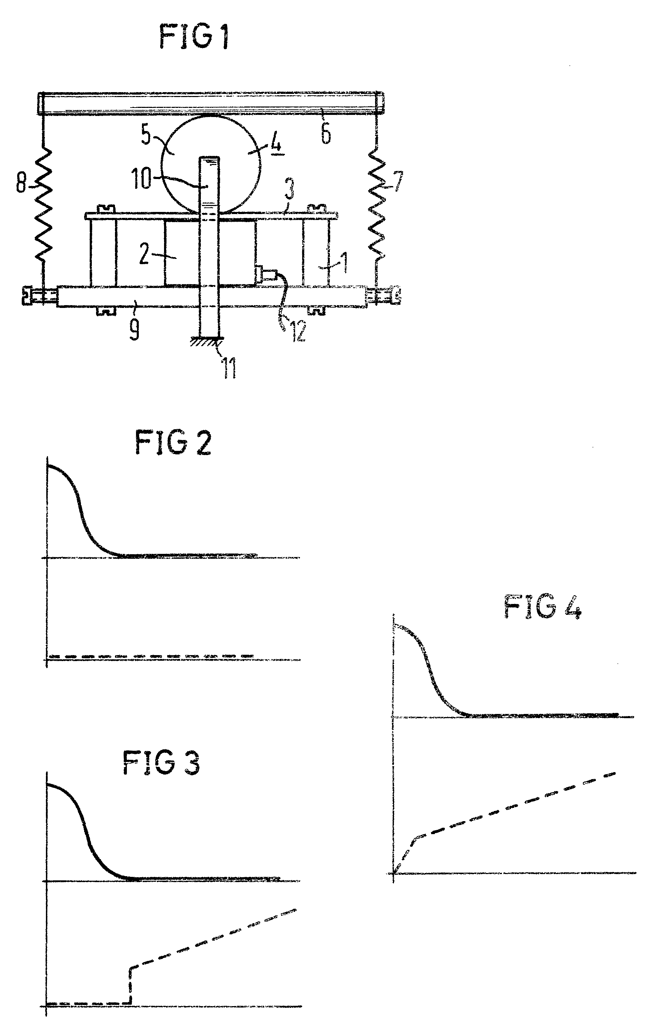

In der Figur 1 ist in einer Sondenhalterung 1 eine Schallsonde 2 dargestellt. Die Halterung ist mit einer Teflonplatte 3 abgedeckt, auf der sich genau gegenüber der Schallsonde ein keramisches Bauelement in Form eines Kaltleiters 4 befindet. Die Kaltleiterelektrode ist mit 5 bezeichnet. Ein Teflonrundstab 6 wird über Federn 7, 8 in Richtung der Grundplatte 9 der Sondenhalterung 1 gezogen. Der Kaltleiter 4 ist ferner zwischen zwei Federn, von denen nur die vordere 10 sichtbar ist, eingespannt, die als elektrische Kontakte dienen. Die Stromzuführung für den Kaltleiter ist mit dem Bezugszeichen 11 versehen. Ein Anschluss, der zu einer nichtdargestellten Elektronik führt, ist mit 12 bezeichnet.

In den Figuren 2 bis 4 ist im oberen Teil auf der Ordinate immer der Strom und im unteren Teil gestrichelt die Zahl der Schallpulse aufgetragen. Die Abszisse ist immer die Zeitachse.

In den Figuren 2 bis 4 sinkt im oberen Teil der Figuren der Wechselstrom nach einer bestimmten Zeit – wie bei Kaltleitern nach Anlegen einer Spannung üblich – ab. Aus dem unteren Teil der Figur 2 ist zu ersehen, dass bei dem dieser Figur zugrundeliegenden Bauelement keine Schallpulse auftreten. Daraus ist zu schliessen, dass keine Vorschädigung vorliegt und keine Schädigung während der elektrischen Belastung entstanden ist.

Aus dem unteren Teil der Figur 3 geht hervor, dass die Probe, die diesem Diagramm zugrundeliegt, ebenfalls keine Vorschädigung aufweist. Während des Schaltversuchs tritt jedoch eine Schädigung auf, die durch eine abrupte und dann stetige Zunahme der Schallpulse nachgewiesen wird.

Der untere Teil der Figur 4 zeigt das Diagramm einer Probe, bei der unmittelbar nach dem Anlegen der Spannung Schallpulse erzeugt werden. Dies sagt aus, dass bereits eine Vorschädigung vorlag.

Mit dem Verfahren nach der Erfindung lassen sich Schädigungen bereits dann deutlich erkennen, wenn eine Erhöhung des Probenwiderstandes noch nicht messbar ist.

**Patentansprüche**

1. Verfahren zur zerstörungsfreien Qualitätsprüfung keramischer Bauelemente aus halbleitender Keramik, insbesondere zur Qualitätsprüfung von Kaltleitern, unter elektrischer Belastung mit Hilfe der Schallemissionsanalyse, dadurch gekennzeichnet, dass eine elektrische Überspannung einmalig an das zu messende Bauelement angelegt wird, wobei gleichzeitig die Schallemissionsanalyse ausgeführt wird und aus dieser danach eine Aussage über den Werkstoffzustand, und zwar über die durch das Anlegen der elektrischen Überspannung eventuell entstehende mechanische Schädigung oder eine bestehende mechanische Vorschädigung des Werkstoffes gewonnen wird.

2. Verfahren nach Anspruch 1, dadurch gekennzeichnet, dass die Schallemissionsanalyse erst unmittelbar nach dem Anlegen der Überspannung aktiviert wird.

3. Vorrichtung zur Durchführung des Verfahrens nach den Ansprüchen 1 und 2 mit Mitteln zum Anlegen der elektrischen Überspannung an das Bauelement über zwei elektrische Kontakte einer Halterung und mit Mitteln zur gleichzeitigen Durchführung der Schallemissionsanalyse über einen Schallaufnehmer, der an der Oberfläche des Bauelementes durch die Halterung gehalten ist, dadurch gekennzeichnet, dass der Schallaufnehmer (2) am Bauelement (4) durch die Halterung federnd gehalten ist, dass die elektrischen Kontakte der Halterung als Federn (10) ausgebildet sind, zwischen die das Bauelement eingespannt ist, wobei alle Teile der Halterung konstruktiv so ausgelegt sind, dass sie sich relativ leicht gegeneinander verdrehen lassen und wobei alle nicht elektrischen Kontaktpunkte dieser Halterung mit dem zu messenden Bauelement aus dem Kunststoff Polytetrafluoräthylen bestehen.

**Claims**

1. A process for the non-destructive quality testing of ceramic components made of a semiconducting ceramic, in particular for the quality testing of negative temperature coefficient thermistors, under electric load with the aid of sound emission analysis, characterised in that an electrical overvoltage is applied once only to the component to be measured, sound emission analysis being simultaneously carried out, and from this analysis information regarding the condition of the material, i.e. regarding the mechanical damage which may possibly have occurred as a result of the application of the electrical overvoltage, or regarding existing preliminary mechanical damage to the material, is subsequently obtained.

2. A process as claimed in Claim 1, characterised in that the sound emission analysis is activated immediately after the application of the overvoltage.

3. Apparatus for carrying out the process as claimed in Claim 1 and 2 having means for applying the electric overvoltage to the component through two electrical contacts of a holder, and means for simultaneously effecting the sound emission analysis by means of a sound recorder which is supported on the surface of the component by the holder, characterised in that the sound recorder (2) is resiliently supported on the component (4) by the holder and that the electrical contacts of the holder are in the form of springs (10) between which the component is clamped, all parts of the holder being so constructed that they can be twisted with respect to one another relatively easily and all nonelectrical points of contact of said holder with the component to be measured are made of the synthetic resin polytetrafluoroethylene.

**Revendications**

1. Procédé pour contrôler, sans destruction, la qualité de composants céramiques en une céramique semiconductrice, plus particulièrement pour contrôler la qualité de conducteurs à froid, sous une charge électrique au moyen de l'analyse d'une émission acoustique, caractérisé par le fait qu'une surtension électrique est appliquée aux composants soumis à la mesure, alors qu'est en même temps réalisée l'analyse de l'émission acoustique et qu'à partir de celle-ci on déduit ensuite une indication concernant l'état du matériau, plus précisément une indication relative à un dommage mécanique dû éventuellement à l'application de la surtension électrique ou à un dommage mécanique qui a préexisté dans le matériau.

2. Procédé selon la revendication 1, caractérisé par le fait que l'analyse de l'émission acoustique est activée immédiatement après l'application d'une surtension.

3. Dispositif pour la mise en œuvre du procédé selon les revendications 1 et 2, avec des moyens pour appliquer la surtension électrique au composant par l'intermédiaire de deux contacts électriques d'un support et avec des moyens pour réaliser simultanément l'analyse de l'émission acoustique au moyen d'un récepteur acoustique maintenu sur la surface du composant au moyen du support, caractérisé par le fait que le récepteur acoustique (2) est maintenu élastiquement sur le composant (4) par le support, que les contacts électriques du support sont réalisés sous la forme de ressorts (10) entre lesquels est serré le composant, tous les éléments du support étant réalisés structurellement de telle manière qu'ils peuvent être décalés assez facilement les uns par rapport aux autres alors que tous les points de contact non électriques de ce support avec le composant à mesurer sont constitués avec une matière plastique qui est le polytétrafluoroéthylène.

# FIG 1

# FIG 2

# FIG 4

# FIG 3